(19) Europäisches Patentamt
European Patent Office
Office européen des brevets

(11) EP 3 680 718 A2

(12) EUROPÄISCHE PATENTANMELDUNG

(43) Veröffentlichungstag:
15.07.2020 Patentblatt 2020/29

(51) Int Cl.:
*G03F 7/20* (2006.01)

(21) Anmeldenummer: 20150217.6

(22) Anmeldetag: 03.01.2020

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR
Benannte Erstreckungsstaaten:
BA ME
Benannte Validierungsstaaten:
KH MA MD TN

(30) Priorität: 10.01.2019 DE 102019200218

(71) Anmelder: Carl Zeiss SMT GmbH
73447 Oberkochen (DE)

(72) Erfinder:
• BUTSCHER, Björn
73431 Aalen (DE)
• WALD, Christian
73432 Aalen (DE)

(74) Vertreter: Zeuner Summerer Stütz
Patent- und Rechtsanwälte
Partnerschaft
Nußbaumstraße 8
80336 München (DE)

(54) STEUERUNGSVORRICHTUNG UND VERFAHREN ZUR STEUERUNG EINES MANIPULATORS BEZÜGLICH EINER PROJEKTIONSBELICHTUNGSANLAGE FÜR DIE MIKROLITHOGRAPHIE

(57) Eine Steuerungsvorrichtung (14, 114) zur Steuerung mindestens eines Manipulators (M1-M4, 36) zur Veränderung eines Parameters einer Projektionsbelichtungsanlage (50)für die Mikrolithographie durch Generierung einer Vorgabe (38, 138) für eine Stellwegsvariable, welche eine mittels des Manipulators vorzunehmende Veränderung des Parameters definiert, wird bereitgestellt. Die Steuerungsvorrichtung ist dazu konfiguriert, aus einer Zustandscharakterisierung (34) der Projektionsbelichtungsanlage die Vorgabe (38, 138) durch Optimierung einer Gütefunktion (42) zu generieren. Eine Gütefunktion umfasst mindestens einen Bestrafungsterm (46) zur Berücksichtigung einer Grenze (44) für eine Eigenschaft der Projektionsbelichtungsanlage als implizite Nebenbedingung und der Bestrafungsterm ist derart formuliert, dass dessen Funktionswert für die Annäherung der Eigenschaft an die Grenze gegen "unendlich" läuft.

Fig. 2

$$H(\mathbf{x}, t) = \cdots + \underbrace{\sum_j p(\overbrace{|M_j\mathbf{x} - b_j|}^{\xi}, \overbrace{t_j \cdot s_j}^{a})}_{46} + \cdots \underbrace{\sum_j \Gamma_{t_j}|t_j|^2}_{48} + \cdots;$$

$$\text{i) } p(\xi, a) = \begin{cases} \left(-\log\left(\frac{a-\xi}{a-\xi_{min}}\right)\right)^k, & \xi \in [\xi_{min}; a[ \ , \ k\epsilon N \\ \infty & , \ \xi \geq a \end{cases}$$

$$\text{ii) } p(\xi, a) = \begin{cases} (a-\xi)^{-k}, & \xi \in [\xi_{min}; a[ \ , \ k\epsilon N \\ \infty & , \ \xi \geq a \end{cases}$$

EP 3 680 718 A2

**Beschreibung**

Die vorliegende Anmeldung beansprucht die Priorität der deutschen Patentanmeldung 10 2019 200 218.8 vom 10. Januar 2019. Die gesamte Offenbarung dieser Patentanmeldung wird durch Bezugnahme in die vorliegende Anmeldung aufgenommen.

Hintergrund der Erfindung

Die Erfindung betrifft eine Steuerungsvorrichtung sowie ein Verfahren zur Steuerung mindestens eines Manipulators zur Veränderung eines Parameters einer Projektionsbelichtungsanlage für die Mikrolithographie. Weiterhin betrifft die Erfindung eine Justieranordnung zur Justierung eines Projektionsobjektivs für die Mikrolithographie sowie eine Projektionsbelichtungsanlage für die Mikrolithographie, jeweils mit einer derartigen Steuerungsvorrichtung.

Eine Projektionsbelichtungsanlage für die Mikrolithographie dient bei der Herstellung von Halbleiter-Bauelementen der Erzeugung von Strukturen auf einem Substrat in Gestalt eines Halbleiterwafers. Dazu umfasst die Projektionsbelichtungsanlage ein mehrere optische Elemente aufweisendes Projektionsobjektiv zum Abbilden von Maskenstrukturen auf den Wafer während eines Belichtungsvorganges.

Zur Gewährleistung einer möglichst präzisen Abbildung der Maskenstrukturen auf den Wafer wird ein Projektionsobjektiv mit möglichst geringen Wellenfrontaberrationen benötigt. Projektionsobjektive werden daher mit Manipulatoren ausgestattet, die es ermöglichen Wellenfrontfehler durch Zustandsveränderung einzelner optischer Elemente des Projektionsobjektivs zu korrigieren. Beispiele für eine derartige Zustandsveränderung umfassen: eine Lageänderung in einem oder mehreren der sechs Starrkörperfreiheitsgrade des betreffenden optischen Elements, eine Beaufschlagung des optischen Elements mit Wärme und/oder Kälte, eine Deformation des optischen Elements oder eine Materialabtragung an einem optischen Element mittels einer Nachbearbeitungseinrichtung. Im Rahmen dieser Anmeldung wird auch eine derartige Nachbearbeitungseinrichtung als Manipulator des Projektionsobjektivs im allgemeinen Sinn verstanden.

Die Berechnung von zur Korrektur einer Aberrationscharakteristik eines Projektionsobjektiv auszuführenden Manipulatorveränderungen erfolgt mittels eines stellwegsgenerierenden Optimierungsalgorithmus, welcher auch "Manipulatorveränderungsmodell" bezeichnet wird. Derartige Optimierungsalgorithmen sind beispielsweise in WO2010/034674A1 und DE10 2015 206 448 A1 beschrieben.

So können aus dem Stand der Technik bekannte Optimierungsalgorithmen zur Lösung des folgenden Optimierungsproblems konfiguriert sein:

$$\min \left\| Mx - b_{mess} \right\|_2^2 \qquad \text{mit} \qquad F_j(x) \leq s_j \qquad (1)$$

Ein derartiges Optimierungsproblem ist dazu konfiguriert, die durch $\left\| Mx - b_{mess} \right\|_2^2$ beschriebene Gütefunktion, auch Meritfunktion bezeichnet, unter Berücksichtigung von durch $F_j(x) \leq s_j$ beschriebenen Nebenbedingungen zu minimieren. Hierbei bezeichnet M eine Sensitivitätsmatrix, x einen Stellwegvektor mit Stellwegen für die einzelnen Manipulatoren, $b_{mess}$ einen Zustandsvektor des Projektionsobjektivs, welcher eine gemessene Aberrationscharakteristik des Projektionsobjektivs beschreibt, $\| \|_2$ die Euklidische Norm, $F_j(x)$ eine geeignete Funktion zur Beschreibung der Nebenbedingungen und $s_j$ einen jeweiligen festen Grenzwert für Eigenschaften des Projektionsobjektivs, wie etwa für Parameter des Zustandsvektors b und/oder für einzelne Stellwege $x_i$.

Unter "Stellweg" wird eine mittels Manipulator-Aktuierung erfolgende Veränderung einer Zustandsgröße eines optischen Elements zum Zweck der Veränderung seiner optischen Wirkung verstanden. Ein derartiger, durch Veränderung einer Zustandsgröße des optischen Elements definierter Stellweg wird über Solländerungsgrößen des zugehörigen Manipulators spezifiziert. Die Manipulation kann beispielsweise in einer Verlagerung des optischen Elements in eine spezielle Richtung, aber auch beispielsweise in einer, insbesondere lokalen oder flächigen, Beaufschlagung des optischen Elements mit Wärme, Kälte, Kräften, Momenten, Licht einer bestimmten Wellenlänge oder Strömen bestehen. Weiterhin kann die Manipulation eine mittels einer Nachbearbeitungseinrichtung vorzunehmende Materialabtragung an einem optischen Element definieren. Die Solländerungsgröße kann beispielsweise im Falle einer Verlagerung eine zurückzulegende Weglänge oder einen zurückzulegenden Winkelbereich definieren.

Die durch $F_j(x) \leq s_j$ definierten Nebenbedingungen geben harte Grenzen für die betreffenden Eigenschaften des Projektionsobjektivs vor, die nicht überschritten werden dürfen. Die schlechte Skalierung der Rechenzeit mit der Problemgröße stellt bei diesem Optimierungsverfahren ein wesentliches Problem dar. Damit ist bei einer größeren Zahl an Manipulator-Freiheitsgraden eine zeiteffiziente Berechnung von Stellwegsvorgaben nicht erreichbar.

Zur Verkürzung der Rechenzeiten ist aus dem Stand der Technik (DE 10 2015 206 448 A1) ein Optimierverfahren bekannt, bei dem die durch die Nebenbedingungen definierten Grenzen mittels einer in der Gütefunktion enthaltenen Bestrafungsfunktion berücksichtigt werden, wobei diese Bestrafungsfunktion auf einer Potenz mit einem geradzahligen Exponenten beruht. Mit diesem Verfahren ist jedoch die exakte Einhaltung der Nebenbedingungen nicht mehr unter allen Bedingungen gewährleistet.

Zugrunde liegende Aufgabe

Es ist eine Aufgabe der Erfindung, eine Steuerungsvorrichtung sowie ein Verfahren der eingangs genannten Art bereitzustellen, womit die vorgenannten Probleme gelöst werden, und insbesondere eine Stellwegsvorgabe in zeiteffizienter Weise unter verbesserter Einhaltung einer Grenze für eine Eigenschaft der Projektionsbelichtungsanlage ermittelt werden kann. Insbesondere soll die Grenze streng eingehalten werden.

Erfindungsgemäße Lösung

Die vorgenannte Aufgabe kann erfindungsgemäß beispielsweise gelöst werden mit einer Steuerungsvorrichtung zur Steuerung mindestens eines Manipulators zur Veränderung eines Parameters einer Projektionsbelichtungsanlage für die Mikrolithographie, insbesondere eines Parameters mindestens eines optischen Elements eines Projektionsobjektivs für die Mikrolithographie, durch Generierung einer Vorgabe für eine Stellwegsvariable, welche eine mittels des Manipulators vorzunehmende Veränderung des Parameters definiert, wobei die Steuerungsvorrichtung dazu konfiguriert ist, aus einer Zustandscharakterisierung der Projektionsbelichtungsanlage, insbesondere des Projektionsobjektivs, die Vorgabe durch Optimierung einer Gütefunktion zu generieren, die Gütefunktion mindestens einen Bestrafungsterm zur Berücksichtigung einer Grenze für eine Eigenschaft der Projektionsbelichtungsanlage, insbesondere des Projektionsobjektivs, als implizite Nebenbedingung umfasst und der Bestrafungsterm derart formuliert ist, dass dessen Funktionswert für die Annäherung der Eigenschaft an die Grenze gegen "unendlich" läuft.

Wie vorstehend erwähnt, kann der mindestens eine von der Steuerungsvorrichtung gesteuerte Manipulator zur Veränderung eines Parameters mindestens eines optischen Elements eines Projektionsobjektivs der Projektionsbelichtungsanlage dienen. Daneben kann der Manipulator insbesondere auch der Justage einer Messmaske oder eines Sensors, der Wellenlänge einer Beleuchtungsstrahlung dienen. Bei der Grenze für die Eigenschaft der Projektionsbelichtungsanlage kann es sich um eine Obergrenze oder eine Untergrenze handeln, allgemein definiert die Grenze eine oder mehrere Nebenbedingungen. Unter dem Bestrafungsterm ist ein Term der Gütefunktion zu verstehen, der die Funktion hat, während der Optimierung einer Annäherung eines die Eigenschaft quantifizierenden Wertes an die Grenze oder zumindest einem Überschreiten der Grenze durch den Wert entgegenzuwirken.

Wie vorstehend erwähnt, ist die erfindungsgemäße Steuerungsvorrichtung dazu konfiguriert, aus einer Zustandscharakterisierung der Projektionsbelichtungsanlage die Vorgabe für eine Stellwegsvariable zu generieren. Dabei muss die Zustandscharakterisierung nicht die einzige Eingangsgröße sein, vielmehr können von der Steuerungsvorrichtung neben der Zustandscharakterisierung auch andere Eingangsgrößen, wie beispielsweise eine Bestrahlungsintensität der Maske oder ein gemessener Umgebungsdruck, zur Ermittlung der Vorgabe für die Stellwegsvariable berücksichtigen werden. Die Stellwegsvariable kann als Vektorvariable konfiguriert sein, deren Vektorelemente jeweils eine mittels eines Manipulators vorzunehmende Justage eines Parameters eines optischen Elements des Projektionsobjektivs definiert.

Bei der Zustandscharakterisierung kann es sich um einen Abbildungsfehler des Projektionsobjektivs handeln. Dieser kann in Form eines Zernike-Bildfehlers oder einer von einem oder mehreren Zernike-Bildfehlern abgeleiteten Größe vorliegen. Weiterhin kann es sich bei dem Abbildungsfehler um einen sogenannten lithographischen Fehler, d.h. einen Fehler im Luft- oder Waferbild der Maskenstruktur, wie etwa einen Overlay-Fehler oder einen Fehler in der Linienbreite, handeln.

Erfindungsgemäß ist der Bestrafungsterm derart formuliert, dass dessen Funktionswert für eine Annäherung der Eigenschaft an die Grenze gegen "unendlich" läuft. Dies kann beispielsweise mittels einer Logarithmusfunktion oder einer gebrochen-rationalen Funktion erfolgen. Durch die erfindungsgemäße Formulierung des Bestrafungsterms wird ein Überschreiten der Grenze wirksam verhindert, wodurch die Einhaltung einer oder mehrerer Nebenbedingung gewährleistet wird. Gleichzeitig wird durch die implizite Berücksichtigung der Nebenbedingung mittels des in der Gütefunktion enthaltenen Bestrafungsterms eine zeiteffiziente Berechnung der Stellwegsvorgabe ermöglicht. Das heißt, die Rechenzeiten der Optimierung können gering gehalten werden und gleichzeitig kann die Einhaltung von Nebenbedingungen gewährleistet werden.

Gemäß einer Ausführungsform nach der Erfindung umfasst der Bestrafungsterm eine Funktion, welche zumindest in einem Abschnitt mindestens einmal stetig differenzierbar ist. Die stetige Differenzierbarkeit erlaubt es dem Optimierer, ein Gradientenverfahren zu nutzen. Per Gradientenverfahren kann die Lösung auf effiziente Weise aufgefunden werden.

Gemäß einer Ausführungsvariante macht der Abschnitt, in dem die Funktion mindestens einmal stetig differenzierbar ist, mehr als 90%, insbesondere mehr als 98%, mehr als 99%, mehr als 99,9% oder mehr als 99,99%, eines durch praktische Randbedingungen beschränkten Definitionsbereichs der Funktion aus. Unter der Beschränkung des Definitionsbereichs durch praktische Randbedingungen ist zu verstehen, dass das Funktionsargument aufgrund von Randbedingungen des Manipulationssystems und/oder der Projektionsbelichtungsanlage in der Praxis nicht alle Werte des aus mathematischer Sicht maximal möglichen Definitionsbereichs annehmen kann. So kann etwa ein Bildfehler möglicherweise nicht ganz auf Null reduziert werden, sondern dieser kann sich dem absoluten Wert Null nur bis zu einem bestimmten Wert annähern. Insbesondere wird ein Definitionsbereich, der aus mathematischer Sicht eine untere oder obere Grenze von -∞ bzw. +∞ aufweist, durch praktische Randbedingungen auf einen endlichen Zahlenwert begrenzt.

Gemäß einer weiteren Ausführungsform liegt die Funktion in numerischer Darstellung mit einer Mindestschrittweite vor. Dabei ist die stetige Differenzierbarkeit dadurch erfüllt, dass an jedem Punkt des Abschnitts, dessen Funktionswert das 10-fache der kleinsten, in einem Rechenprogramm der Steuerungsvorrichtung darstellbaren Zahl übersteigt, ein durch lineare Approximation bestimmter Funktionswert eines zugeordneten Approximationspunktes um höchstens 50%, insbesondere um höchstens 20%, höchstens 10%, höchstens 5% oder um höchstens 1%, vom tatsächlichen Funktionswert abweicht. Der dem jeweiligen Punkt zugeordnete Approximationspunkt ist um mindestens das Doppelte, insbesondere um mindestens das Fünffache oder mindestens das Zehnfache, der Mindestschrittweite von dem Punkt beabstandet. Insbesondere gilt dies für jeden Punkt des Abschnitts, dessen Funktionswert das 1000-fache oder $10^6$-fache der kleinsten im Rechenprogramm der Steuerungsvorrichtung darstellbaren Zahl übersteigt. Gemäß einer weiteren Ausführungsform ist die Funktion in zumindest einem Abschnitt mindestens zweimal stetig differenzierbar. Dies ermöglicht dem Optimierer mittels der zweiten Ableitung, ein per Gradientenverfahren ermitteltes Ziel schneller aufzufinden.

Gemäß einer Ausführungsvariante liegt die Funktion in numerischer Darstellung mit einer Mindestschrittweite vor und die mindestens zweimalige stetige Differenzierbarkeit ist dadurch erfüllt, dass an jedem Punkt des Abschnitts, dessen Funktionswert das 10-fache der kleinsten, in einem Rechenprogramm der Steuerungsvorrichtung darstellbaren Zahl übersteigt, ein durch quadratische Approximation bestimmter Funktionswert eines zugeordneten Approximationspunktes um höchstens 50%, insbesondere um höchstens 20%, höchstens 10%, höchstens 5% oder um höchstens 1%, vom tatsächlichen Funktionswert abweicht, wobei der dem jeweiligen Punkt zugeordnete Approximationspunkt um mindestens das Doppelte, insbesondere um mindestens das Fünffache oder um mindestens das Zehnfache der Mindestschrittweite von dem Punkt beabstandet ist. Insbesondere gilt dies für jeden Punkt des Abschnitts, dessen Funktionswert das 1000-fache oder $10^6$-fache der kleinsten im Rechenprogramm der Steuerungsvorrichtung darstellbaren Zahl übersteigt.

Gemäß einer weiteren Ausführungsform umfasst der Bestrafungsterm zumindest näherungsweise eine Logarithmusfunktion und/oder eine gebrochen-rationale Funktion. Diese Funktionen ermöglichen die Einhaltung der Grenze auf besonders wirksame Weise. Im Falle der Logarithmusfunktion kann diese als analytische Funktion oder aber auch in tabellarischer Darstellung vorliegen. Unter der Angabe "zumindest näherungsweise" ist hier zu verstehen, dass der Bestrafungsterm eine Funktion umfasst, die durch eine Logarithmusfunktion und/oder eine gebrochen-rationale Funktion dargestellt wird oder diesen Funktionen zumindest derart ähnlich ist, dass deren Wirkung im Bestrafungsterm mit den genannten Funktionen vergleichbar ist.

Gemäß einer weiteren Ausführungsform ist der Bestrafungsterm derart formuliert, dass dessen Funktionswert bei Überschreiten der Grenze als "unendlich" definiert ist. Bei Nutzung von relativ großen Schrittweiten durch den Optimierungsalgorithmus kann die Grenze trotz der genannten Formulierung des Bestrafungsterms mit dem gegen "unendlich" laufenden Grenzwert überschritten werden. Durch die Definition des Funktionswerts des Bestrafungsterms bei Überschreiten als "unendlich" kann sichergestellt werden, dass etwa bei Überschreiten der Grenze durch die Nutzung von relativ großen Schrittweiten während der Optimierung, diese Überschreitung im weiteren Verlauf der Optimierung wieder rückgängig gemacht wird.

Gemäß einer weiteren Ausführungsform ist die Steuerungsvorrichtung dazu konfiguriert, die Vorgabe durch Optimierung der Gütefunktion mittels der als erste Optimierungsvariable dienenden Stellwegsvariablen sowie mittels einer weiteren Optimierungsvariablen einer anderen Kategorie durchzuführen. Unter der weiteren Optimierungsvariablen einer anderen Kategorie ist zu verstehen, dass diese Optimierungsvariable keine Stellwegsvariable eines Manipulators ist.

Gemäß einer weiteren Ausführungsform umfasst die weitere Optimierungsvariable einen Skalierungsfaktor zur Skalierung der Grenze. Gemäß einer Ausführungsvariante umfasst die Gütefunktion einen weiteren Bestrafungsterm zur Begrenzung des Wertes des Skalierungsfaktors. Dieser Bestrafungsterm kann beispielsweise den Skalierungsfaktor im Quadrat oder einer höheren Potenz enthalten.

Gemäß einer weiteren Ausführungsform umfasst die Grenze eine Mehrzahl an Einzelgrenzwerten für eine jeweilige Eigenschaft der Projektionsbelichtungsanlage und die weitere Optimierungsvariable umfasst eine Mehrzahl an Skalierungsfaktoren zur Skalierung der Einzelgrenzwerte sowie einen Gruppengrenzwert, welcher von zumindest einem Teil der Einzelgrenzwerte nicht überschritten werden darf. Der weitere Bestrafungsterm der Gütefunktion ist dazu konfiguriert, sowohl die Werte der Skalierungsfaktoren als auch des Gruppengrenzwerts zu begrenzen. Weiterhin kann die weitere Optimierungsvariable mehrere Gruppengrenzwerte sowie einen Übergruppengrenzwert umfassen, wobei die Gruppengrenzwerte unterschiedliche Gruppen an Skalierungsfaktoren betreffen und der Übergruppengrenzwert von keinem der Gruppengrenzwerte überschritten werden darf. Gemäß einer weiteren Ausführungsform kann die Gütefunktion einen weiteren Bestrafungsterm zur Begrenzung des Gruppengrenzwerts umfassen. Dieses Konzept kann auf weitere Kaskadierungen mit Über-Übergruppengrenzwerten erweitert werden.

Gemäß weiterer Ausführungsformen weist die Eigenschaft der Projektionsbelichtungsanlage, für die der Bestrafungsterm eine Grenze umfasst, einen Abbildungsfehler eines Projektionsobjektivs der Projektionsbelichtungsanlage und/oder die Vorgabe für die Stellwegsvariable auf. In der Variante, in der die Eigenschaft zumindest die Vorgabe für die Stellwegsvariable umfasst, betrifft der erste Bestrafungsterm eine Randbedingung für mindestens einen der Manipulatorstellwege. Insbesondere kann der erste Bestrafungsterm eine jeweilige Grenze für mindestens einen Abbildungsfehler und für mindestens eine Stellwegsvariable umfassen.

Weiterhin wird erfindungsgemäß eine Justieranordnung zur Justierung eines Projektionsobjektivs für die Mikrolithographie bereitgestellt. Die erfindungsgemäße Justieranordnung umfasst eine Messvorrichtung zur Ermittlung einer Zustandscharakterisierung des Projektionsobjektivs sowie eine Steuerungsvorrichtung gemäß einer der vorausgehenden Ausführungsformen bzw. Ausführungsvarianten zur Generierung der Vorgabe für eine Stellwegsvariable aus der Zustandscharakterisierung.

Weiterhin wird erfindungsgemäß eine Projektionsbelichtungsanlage für die Mikrolithographie bereitgestellt. Die erfindungsgemäße Projektionsbelichtungsanlage umfasst mindestens einen Manipulator, welcher dazu konfiguriert ist, einen Parameter eines optischen Elements der Projektionsbelichtungsanlage zu verändern, sowie eine Steuerungsvorrichtung gemäß einer der vorausgehenden Ausführungsformen bzw. Ausführungsvarianten zur Steuerung des mindestens einen Manipulators. Gemäß einer Ausführungsform ist der mindestens eine Manipulator dazu konfiguriert, einen Parameter eines optischen Elements eines Projektionsobjektivs der Projektionsbelichtungsanlage zu verändern.

Die vorgenannte Aufgabe kann weiterhin beispielsweise gelöst werden mit einem Verfahren zum Steuern mindestens eines Manipulators zur Veränderung eines Parameters einer Projektionsbelichtungsanlage, inbesondere mindestens eines optischen Elements eines Projektionsobjektivs für die Mikrolithographie. Das erfindungsgemäße Verfahren umfasst ein Generieren einer Vorgabe für eine Stellwegsvariable für den mindestens einen Manipulator aus einer Zustandscharakterisierung der Projektionsbelichtungsanlage, inbesondere des Projektionsobjektivs, durch Optimierung einer Gütefunktion, wobei die Gütefunktion mindestens einen Bestrafungsterm zur Berücksichtigung einer Grenze für eine Eigenschaft des Projektionsobjektivs als implizite Nebenbedingung umfasst und der Bestrafungsterm derart formuliert ist, dass dessen Funktionswert für die Annäherung der Eigenschaft an die Grenze gegen "unendlich" läuft. Weiterhin umfasst das erfindungsgemäße Verfahren ein Verändern des Parameters der Projektionsbelichtungsanlage, inbesondere des mindestens einen optischen Elements des Projektionsobjektivs, mittels des mindestens einen Manipulators anhand der generierten Vorgabe für die Stellwegsvariable.

Die bezüglich der vorstehend aufgeführten Ausführungsformen, Ausführungsbeispiele bzw. Ausführungsvarianten, etc. der erfindungsgemäßen Steuerungsvorrichtung angegebenen Merkmale können entsprechend auf das erfindungsgemäße Steuerungsverfahren übertragen werden. Diese und andere Merkmale der erfindungsgemäßen Ausführungsformen werden in der Figurenbeschreibung und den Ansprüchen erläutert. Die einzelnen Merkmale können entweder separat oder in Kombination als Ausführungsformen der Erfindung verwirklicht werden. Weiterhin können sie vorteilhafte Ausführungsformen beschreiben, die selbstständig schutzfähig sind und deren Schutz ggf. erst während oder nach Anhängigkeit der Anmeldung beansprucht wird.

Kurzbeschreibung der Zeichnungen

Die vorstehenden, sowie weitere vorteilhafte Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:

Fig. 1 eine Veranschaulichung einer erfindungsgemäßen Ausführungsform einer Justieranordnung zur Justierung eines Projektionsobjektivs für die Mikrolithographie mit einer Messvorrichtung zur Ermittlung einer Zustandscharakterisierung des Projektionsobjektivs sowie einer Steuerungsvorrichtung zur Steuerung von im Projektionsobjektiv integrierten Manipulationen sowie von Manipulatoren in Gestalt einer Nachbearbeitungseinrichtung,

Fig. 2 eine Veranschaulichung des Aufbaus einer Gütefunktion, welche einem von der Steuerungsvorrichtung ausgeführten Optimierungsalgorithmus zugrunde liegt,

Fig. 3 ein Diagramm zur Veranschaulichung der Wirkungsweise einer erfindungsgemäßen Ausführungsform der Gütefunktion,

Fig. 4 ein Diagramm zur Veranschaulichung der Wirkungsweise eines Vergleichsbeispiels für die Gütefunktion, sowie

Fig. 5 eine Veranschaulichung einer erfindungsgemäßen Ausführungsform einer Projektionsbelichtungsanlage für die Mikrolithographie mit einem Projektionsobjektiv sowie einer Steuerungsvorrichtung zur Steuerung von Manipulatoren des Projektionsobjektivs.

Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden.

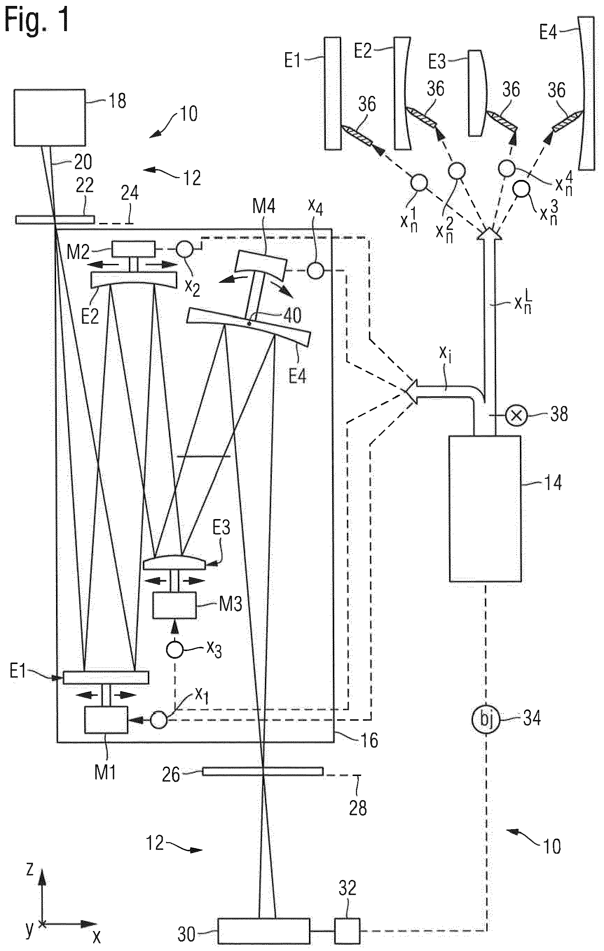

Zur Erleichterung der Beschreibung ist in der Zeichnung ein kartesisches xyz-Koordinatensystem angegeben, aus dem sich die jeweilige Lagebeziehung der in den Figuren dargestellten Komponenten ergibt. In Fig. 1 verläuft die y-Richtung senkrecht zur Zeichenebene in diese hinein, die x-Richtung nach rechts und die z-Richtung nach oben.

Fig. 1 zeigt eine Justieranordnung 10 zur Justierung eines Projektionsobjektivs 16 einer Projektionsbelichtungsanlage für die Mikrolithographie. Die einzelnen Komponenten der Justieranordnung können dabei separat voneinander angeordnet sein oder alternativ in eine einheitliche Anlage integriert sein. Die Justieranlage 10 umfasst eine Messvorrichtung 12 zur Ermittlung einer Zustandscharakterisierung 34 des Projektionsobjektivs 16 sowie eine Steuerungsvorrichtung 14 in Gestalt eines sogenannten Stellwegsermittlers zur Generierung eines Stellwegbefehls 38 aus der Zustandscharakterisierung 34.

Das Projektionsobjektiv 16 dient zum Abbilden von Maskenstrukturen aus einer Objektebene 24 in eine Bildebene 28 und kann auf Belichtungsstrahlung unterschiedlicher Wellenlängen ausgelegt sein, wie z.B. 248 nm oder 193 nm. In der vorliegenden Ausführungsform ist das Projektionsobjektiv 16 auf eine Wellenlänge im EUV-Wellenlängenbereich, z.B. 13,5 nm, ausgelegt.

Die Messvorrichtung 12 ist zum Vermessen von Wellenfrontfehlern des Projektionsobjektivs 16 konfiguriert und umfasst auf der Eingangsseite des Projektionsobjektivs 16 eine Beleuchtungseinrichtung 18 und eine Messmaske 22 sowie auf der Ausgangsseite des Projektionsobjektivs ein Sensorelement 26, einen Detektor 30 sowie eine Auswerteeinrichtung 32. Die Messmaske 22 ist in Fig. 1 als Element in Transmission dargestellt. Gemäß einer bevorzugten Ausführungsform wird die Messmaske 22 jedoch in Reflexion betrieben. Die Beleuchtungseinrichtung 18 ist dazu konfiguriert eine Messstrahlung 20 mit der Betriebswellenlänge des zu testenden Projektionsobjektivs 16, im vorliegenden Fall in Gestalt von EUV-Strahlung, zu erzeugen und diese auf die Messmaske 22, welche in der Objektebene 24 angeordnet ist, einzustrahlen. Unter EUV-Strahlung ist im Rahmen dieser Anmeldung elektromagnetische Strahlung einer Wellenlänge kleiner als 100 nm, insbesondere einer Wellenlänge von etwa 13,5 nm oder etwa 6,7 nm zu verstehen. Die Messmaske 22, oft auch "Kohärenzmaske" bezeichnet, weist eine erste periodische Struktur auf. In der Bildebene 28 ist das Sensorelement 26 in Gestalt eines Bildgitters angeordnet, welches eine zweite periodische Struktur aufweist. Auch können Schachbrettstrukturen in der Messmaske 22 mit Schachbrettstrukturen im Sensorelement 26 kombiniert werden. Auch andere, dem Fachmann aus dem Gebiet der Scherinterferometrie oder der Punktbeugungsinterferometrie bekannte, Kombinationen von periodischen Strukturen können Verwendung finden. Das Sensorelement 26 ist in Fig. 1 als Element in Transmission dargestellt, insbesondere kann das Sensorelement 26 jedoch auch in Reflexion betrieben werden.

Unterhalb des Sensorelements 26, und zwar in einer zur Pupillenebene des Projektionsobjektivs 16 konjugierten Ebene, ist ein zweidimensional-auflösender Detektor 30 in Gestalt einer Kamera angeordnet. Das Sensorelement 26 und der Detektor 30 bilden zusammen ein Sensormodul. Die Messmaske 22, und das Sensormodul bilden ein dem Fachmann bekanntes Scherinterferometer oder Punktbeugungsinterferometer und dienen dazu, Wellenfrontfehler des Projektionsobjektivs 16 zu vermessen. Dazu werden insbesondere dem Fachmann bekannte Phasenschiebeverfahren angewendet.

Die Auswerteeinrichtung 32 ermittelt aus den vom Detektor 30 aufgezeichneten Intensitätsmustern die Zustandscharakterisierung 34 des Projektionsobjektivs 16. Gemäß der vorliegenden Ausführungsform umfasst die Zustandscharakterisierung 34 einen die Wellenfrontfehler des Projektionsobjektivs 16 charakterisierenden Satz an Zernikekoeffizienten $b_j$.

In der vorliegenden Anmeldung werden, wie beispielsweise in den Abschnitten [0125] bis [0129] von US 2013/0188246A1 beschrieben, die aus z.B. Kapitel 13.2.3 des Lehrbuchs "Optical Shop Testing", 2nd Edition (1992) von Daniel Malacara, Hrsg. John Wiley & Sons, Inc. bekannten Zernikefunktionen $Z_m^n$ gemäß der sogenannten Fringe-Sortierung mit Zj bezeichnet werden, wobei dann bj die den jeweiligen Zernike-Polynomen (auch "Zernike-Funktionen" bezeichnet) zugeordnete Zernike-Koeffizienten sind. Die Fringe-Sortierung ist beispielsweise in Tabelle 20-2 auf Seite 215 des "Handbook of Optical Systems", Vol. 2 von H. Gross, 2005 Wiley-VCH Verlag GmbH & Co. KGaA, Weinheim veranschaulicht. Eine Wellenfrontabweichung $W(\rho,\Phi)$ an einem Punkt in der Bildebene des Projektionsobjektivs wird in Abhängigkeit von den Polarkoordinaten $(\rho, \Phi)$ in der Pupillenebene wie folgt entwickelt:

$$W(\rho,\Phi) = \sum_j b_j \cdot Z_j(\rho,\Phi) \qquad (2)$$

Während die Zernike-Polynome mit $Z_j$, d.h. mit tiefergestelltem Index j, bezeichnet werden, werden im Rahmen dieser Anmeldung die Zernike-Koeffizienten mit $b_j$ bezeichnet. An dieser Stelle sei angemerkt, dass in der Fachwelt die Zernike-Koeffizienten $b_j$ oft auch mit Zj, d.h. mit normal gestelltem Index, wie beispielsweise Z5 und Z6 für Astigmatismus, bezeichnet werden.

Die von der Auswerteeinrichtung 32 der Messvorrichtung 12 ermittelte Zustandscharakterisierung 34 wird an die Steuerungsvorrichtung 14 übergeben, welche daraus den Stellwegbefehl 38 in Form einer Stellwegsvariablen **x** erzeugt. Die Stellwegsvariable **x** hat in der vorliegenden Ausführungsform die Form eines Vektors und umfasst Stellwege $x_i$ sowie Stellwege $x_n^L$. Diese Stellwege $x_i$ dienen der Steuerung von Manipulatoren $M_s$ des Projektionsobjektivs 16, während die Stellwege $x_n^L$ der Steuerung einer Nachbearbeitungseinrichtung 36 zur mechanischen Nachbearbeitung von optischen Elementen des Projektionsobjektivs 16 dienen. Im Rahmen dieser Anmeldung werden sowohl die Manipulatoren $M_s$ also auch die Nachbearbeitungseinrichtung 36 als Manipulatoren für des Projektionsobjektiv 16 im allgemeinen Sinn verstanden. Allgemein gesprochen umfasst der Stellwegbefehl 38 mit den Stellwegen $x_i$ sowie den Stellwegen $x_n^L$ Vorgaben für Stellwegsvariablen, welche mittels Manipulatoren vorzunehmende Veränderungen eines jeweiligen Parameters eines oder mehrerer optischer Elemente des Projektionsobjektivs 16 definieren, wobei die zu verändernden Parameter der optischen Elemente insbesondere mittels der Manipulatoren $M_s$ einstellbare Lageanordnungen der optischen Elemente oder mittels der Nachbearbeitungseinrichtung 36 vornehmbare Formzustände umfassen können.

Das Projektionsobjektiv 16 weist in der Ausführungsform gemäß Fig. 1 lediglich vier optische Elemente E1 bis E4 auf. Alle optischen Elemente sind beweglich gelagert. Dazu ist jedem der optischen Elemente E1 bis E4 ein jeweiliger Manipulator $M_s$, und zwar jeweils einer der Manipulatoren M1 bis M4, zugeordnet. Die Manipulatoren M1, M2 und M3 ermöglichen jeweils eine Verschiebung der zugeordneten optischen Elemente E1, E2 und E3 in x- und in y-Richtung und damit im Wesentlichen parallel zur Ebene, in der die jeweilige reflektierende Oberfläche der optischen Elemente liegt.

Der Manipulator M4 ist dazu konfiguriert, das optische Element E4 durch Drehung um eine parallel zur y-Achse angeordnete Kippachse 40 zu verkippen. Damit wird der Winkel der reflektierenden Oberfläche von E4 gegenüber der einfallenden Strahlung verändert. Weitere Freiheitsgrade für die Manipulatoren sind denkbar. So kann beispielsweise eine Verschiebung eines betreffenden optischen Elements quer zu seiner optischen Oberfläche oder eine Rotation um eine senkrecht zur reflektierenden Oberfläche stehende Referenzachse vorgesehen sein.

Allgemein gesprochen, ist jeder der hier dargestellten Manipulatoren M1 bis M4 dazu vorgesehen, durch eine Verlagerung des zugeordneten optischen Elements E1 bis E4 unter Ausführung einer Starrkörperbewegung entlang eines vorgegebenen Stellwegs eine Veränderung eines Parameters eines entsprechenden optischen Elements zu bewirken. Ein derartiger Stellweg kann beispielsweise Translationen in unterschiedlichen Richtungen, Verkippungen und/oder Rotationen in beliebiger Weise kombinieren. Alternativ oder zusätzlich können auch Manipulatoren vorgesehen werden, welche dazu konfiguriert sind, eine anders geartete Veränderung eines Parameters des zugeordneten optischen Elements durch entsprechende Aktuierung des Manipulators vorzunehmen. Diesbezüglich kann eine Aktuierung beispielsweise durch eine Beaufschlagung des optischen Elements mit einer bestimmten Temperaturverteilung oder einer bestimmten Kräfteverteilung erfolgen. In diesem Fall kann der Stellweg durch eine Veränderung der Temperaturverteilung am optischen Element bzw. das Anlegen einer lokalen Spannung an einem als deformierbare Linse bzw. als deformierbarer Spiegel ausgeführten optischen Element sein.

Die vom Stellwegbefehl 38 umfassten Stellwege $x_i$ enthalten im gezeigten Fall die Stellwege $x_1$, $x_2$, $x_3$ sowie $x_4$, welche von den Manipulatoren M1 bis M4 auszuführende Veränderungen mindestens eines Parameters eines oder mehrerer der optischen Elemente E1 bis E4 vorgeben und damit der Steuerung der Manipulatoren M1 bis M4 des Projektionsobjektivs 16 dienen. Die ermittelten Stellwege $x_1$ bis $x_4$ werden den einzelnen Manipulatoren M1 bis M4 über Stellwegsignale übermittelt und geben diesen jeweilige auszuführende Korrekturstellwege vor. Diese definieren entsprechende Verlagerungen der zugeordneten optischen Elemente E1 bis E4 zur Korrektur aufgetretener Wellenfrontfehler des Projektionsobjektivs 16. Für den Fall, in dem ein Manipulator mehrere Freiheitsgrade aufweist, können diesem auch mehrere Stellwege $x_i$ übermittelt werden.

Die weiterhin vom Stellwegbefehl 38 umfassten Stellwege $x_n^L$ enthalten im gezeigten Fall die Stellwege $x_n^1$, $x_n^2$, $x_n^3$ und $x_n^4$, welcher der Steuerung der Nachbearbeitungseinrichtung 36 zur jeweiligen mechanischen Nachbearbeitung der optischen Elemente E1, E2, E3 bzw. E4 des Projektionsobjektivs 16 und damit ebenfalls der Veränderung mindestens eines Parameters eines oder mehrerer der optischen Elemente E1 bis E4 dienen. Die Stellwege $x_n^1$ bis $x_n^4$ dienen damit wie die Stellwege $x_1$ bis $x_4$ der Korrektur aufgetretener Wellenfrontfehler des Projektionsobjektivs 16. Unter der Nachbearbeitungseinrichtung 36 ist eine Einrichtung zur mechanischen Abtragung von Material an einer optischen Oberfläche eines optischen Elements in Gestalt einer Linse oder eines Spiegels zu verstehen. Diese Abtragung ist der Herstellung des optischen Elements nachgelagert und dient insbesondere dazu, die Form einer Oberfläche zu verändern. Die vorzunehmende Veränderung der Oberflächenform ist dabei asphärisch (sie muss darüber hinaus auch nicht rotationssymmetrisch sein). Daher wird die zu verändernde Oberfläche als Korrekturasphäre bezeichnet. Insbesondere kann ein bereits im Projektionsobjektiv 16 montiertes optisches Element zur Nachbearbeitung ausgebaut und danach wieder ins Projektionsobjektiv eingebaut werden. Als Nachbearbeitungseinrichtung 36 kann insbesondere eine üblicherweise zur mechanischen Bearbeitung von Korrekturasphären verwendete Abtragungseinrichtung verwendet werden. Die Abtragungen werden nachstehend daher auch als "Korrekturasphären-Abtragungen" bezeichnet. Zur mechanischen Bearbeitung kann beispielsweise ein Ionenstrahl zum Einsatz kommen. Damit lassen sich beliebige Korrekturprofile in ein nachzubearbeitendes optisches Element einarbeiten.

Neben den vorstehend beschriebenen Stellwegen $x_i$ für die Manipulatorik, die ständig oder vorübergehend an die Steuerungsvorrichtung 14 angeschlossen sein kann (im vorliegenden Ausführungsbeispiel die Manipulatoren M1 bis M4) sowie den Stellwegen $x_n^L$ für die Korrekturasphären-Nachbearbeitungseinrichtung 36 kann gemäß weiterer hier nicht im Detail veranschaulichter Ausführungsformen der Stellwegsbefehl 38 auch weitere Stellwege umfassen. Diese können Stellwege zur Verstellung weiterer ständig mittels der Steuerungsvorrichtung 14 ansteuerbarer Freiheitsgrade, wie der Betriebswellenlänge oder der Position der Messmaske 22 oder des Sensorelements 26 umfassen. Weiterhin können diese Stellwege manuell manipulierbarer Freiheitsgrade sowie Eingriffe in den mechanischen Aufbau des Projektionsobjektivs 16 definierende Stellwege umfassen. Derartige Eingriffe können eine Änderung von Abstimmringen oder Fassungspositionen, die eine partielle Demontage und Remontage des Objektivs und damit üblicherweise auch einen Ausbau des Objektivs aus einer Justieranordnung erfordern, betreffen.

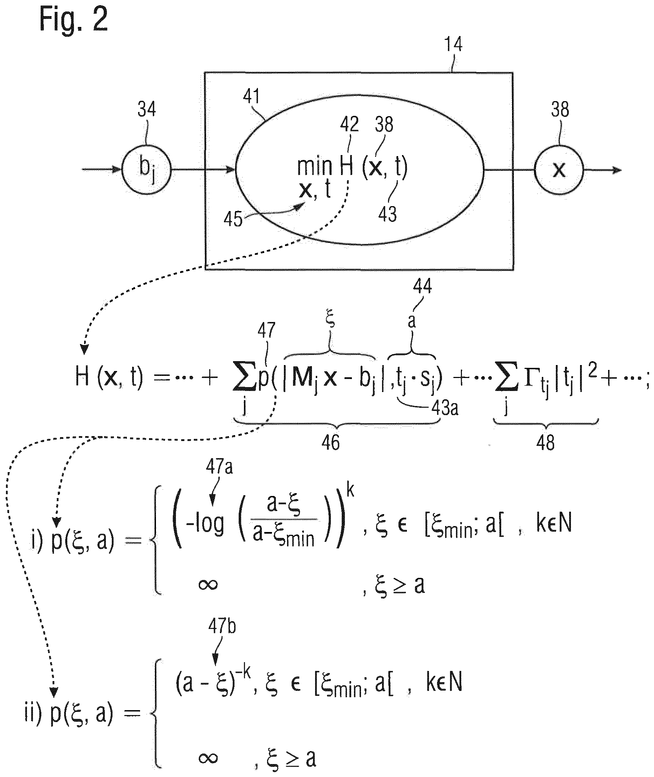

Die Funktionsweise der Steuerungsvorrichtung 14 wird nachstehend exemplarisch mit Bezug auf Fig. 2 veranschaulicht. Diese ist zur Ausführung eines stellwegsgenerierenden Optimierungsalgorithmus 41 konfiguriert. Der Optimierungsalgorithmus 41 dient der Optimierung einer in Fig. 2 mit dem Bezugszeichen 42 gekennzeichneten Gütefunktion H, auch Meritfunktion genannt.

Wie bereits vorstehend erwähnt, werden die Stellwege des vom Optimierungsalgorithmus zu generierenden Stellwegbefehls 38 mit einer vektoriellen Stellwegsvariablen **x** beschrieben, welche die Stellwege $x_i$ der im Projektions-objektiv 16 vorgesehenen Manipulatoren M1 bis M4 sowie die Stellwege $x_n^L$ der Steuerung der Korrekturasphären-Nachbearbeitungseinrichtung 36 umfassen. Die Zustandscharakterisierung 34 wird mit einem Zustandsvektor **b** beschrieben, dessen Vektorkomponenten in der hier beschriebenen Ausführungsform die vorstehend erwähnten Zernike-Koeffizienten bj sind. Die Zernike-Koeffizienten bj werden auch als Zustandsparameter bezeichnet. Gemäß weiterer Ausführungsformen kann der Zustandsvektor **b** neben Zernike-Koeffizienten oder alternativ dazu Parameter von Luftbildgrößen und/oder eine direkte zweidimensionale Wellenfrontdarstellung und/oder aus den vorstehenden Größen abgeleitete Größen, wie beispielsweise Linearkombinationen, umfassen.

Die Sensitivitäten der Manipulatoren, vorliegend der Manipulatoren M1 bis M4 sowie der Nachbearbeitungseinrichtung 36, in Bezug auf deren Freiheitsgrade bei einer Zustandsveränderung werden gemäß einer Ausführungsvariante mittels einer Sensitivitätsmatrix **M** beschrieben. Dabei beschreibt die Sensitivitätsmatrix **M** den Zusammenhang zwischen einer Verstellung eines Freiheitsgrades i eines Manipulators um einen Standard-Stellweg $x_i^0$ und einer daraus resultierenden Veränderung des Zustandsvektors **b** des Projektionsobjektivs 16. Die einzelnen, jeweils einen der Zernike-Koeffizienten bj betreffenden Zeilen der Sensitivitätsmatrix **M**, werden in Fig. 2 mit **M$_j$** bezeichnet.

Die Gütefunktion H ist in der Ausführungsform gemäß Fig. 2 als Funktion der Stellwegsvariablen **x** sowie einer nachstehend näher erläuterten Skalierungsgröße t (Bezugszeichen 43) formuliert. Die Skalierungsgröße t umfasst einen

oder mehrere Skalierungsfaktoren $t_j$ (Bezugszeichen 43a) zur Skalierung eines jeweiligen Grenzwerts $a_j$, welcher bei der Optimierung der Gütefunktion von einer jeweiligen Eigenschaft des Projektionsobjektivs 16, im vorliegenden Ausführungsbeispiel in Form des entsprechenden Zernike-Koeffizienten bj (Bezugszeichen 34), nicht überschritten werden darf. Die Grenzwerte $a_j$ werden dabei von den Skalierungsfaktoren $t_j$ in Bezug auf einen jeweiligen Ausgangsgrenzwert $s_j$ skaliert ($a_j = t_j \cdot s_j$). Die Gesamtheit der Grenzwerte aj werden als Grenze a (Bezugszeichen 44) bezeichnet. Grenzwerte aj werden in diesem Text auch als Einzelgrenzwerte bezeichnet. Gemäß einer weiteren, in Fig. 2 nicht weiter dargestellten, Ausführungsform kann die Grenze a neben den Grenzwerten für die Zernikekeffizienten bj auch Grenzwerte für weitere Eigenschaften des Projektionsobjektivs 16 umfassen. Diese können Grenzwerte $a_{Mi}$ für die Stellwege $x_i$ des Manipulatorsystems M1 bis M4 bzw. 36 umfassen. Die Grenzwerte $a_{Mi}$ definieren Randbedingungen für die Manipulatorstellwege, die sich etwa aus den technisch bedingten Maximalauslenkungen der Manipulatoren M1 bis M4 und deren Ist-Positionen ergeben können. Der Grund für eine technisch bedingte Maximalauslenkung kann etwa in mechanischen Grenzen der Manipulatoren oder auch in anderen technischen Randbedingungen, wie etwa einer Begrenzung der Schrittweite aus Genauigkeits- oder Geschwindigkeitsgründen, liegen.

Der stellwegsgenerierende Optimierungsalgorithmus 41 ist gemäß der Ausführungform nach Fig. 2 zur Lösung des folgenden Optimierungsproblems konfiguriert:

$$\min_{x,t} H(x,t) \tag{3}$$

Dabei dienen die Stellwegsvariable $x$ und die Skalierungsgröße t als Optimierungsvariablen 45, worunter insbesondere zu verstehen ist, dass eine oder mehrere der Vektorkomponenten der Stellwegsvariable $x$ und eine oder mehrere der Komponenten $t_j$ der Skalierungsgröße t bei der Ausführung des Optimierungsalgorithmus 41 als Optimierungsvariablen 45 dienen. Damit dient neben der Stellwegsvariablen $x$ mit der Skalierungsgröße t auch eine Variable einer anderen Kategorie, d.h. einer nicht Stellwegsvariablen betreffenden Kategorie, als Optimierungsvariable 45. Nähere Angaben zur prinzipiellen Lösung eines derartigen Optimierungsproblems können z.B. aus WO2010/034674A1, insbesondere Seiten 38 bis 45, entnommen werden.

Die Gütefunktion H gemäß des hier erläuterten Ausführungsbeispiels lautet wie folgt:

$$H(x,t) = \cdots + \sum_j p\left(\left|M_j\,x - b_j\right|, t_j \cdot s_j\right) + \cdots \sum_j \Gamma_{t_j}\left|t_j\right|^2 + \cdots \tag{4}$$

Mit anderen Worten umfasst die Gütefunktion H zumindest einen ersten Bestrafungsterm 46 der Form

$$\sum_j p\left(\left|M_j\,x - b_j\right|, t_j \cdot s_j\right) \tag{5}$$

Dieser Term dient der Berücksichtigung der vorstehend erwähnten Grenze a für eine oder mehrere Eigenschaften des Projektionsobjektivs 16 in Form von Zernike-Koeffizienten $b_j$ und ggf. Manipulatorstellwegen in der Gütefunktion H als implizite Nebenbedingung.

Der Bestrafungsterm 46 umfasst eine Summe an in Fig. 2 mit dem Bezugszeichen 47 gekennzeichneten Bestrafungsfunktionen p($\xi$, a), wobei a die vorstehend genannte Grenze und $\xi$ gemäß des hier erläuterten Ausführungsbeispiels wie folgt definiert ist:

$$\xi = \left|M_j\,x - b_j\right| \tag{6}$$

Hierbei bezeichnen $M_j$ die Zeilen der Sensitivitätsmatrix $M$, $x$ die Stellwegsvariable und bj die Zernike-Koeffizienten, wie jeweils zuvor beschrieben.

Für die Bestrafungsfunktion p($\xi$, a) sind in Fig. 2 zwei Ausführungsvarianten dargestellt, zum einen unter i) in der Form

$$p(\xi, a) = \begin{cases} \left(-\log\left(\dfrac{a-\xi}{a-\xi_{min}}\right)\right)^k, & \xi \in [\xi_{min}; a[ \,, & k \in \mathbb{N} \\ \\ \infty & , & \xi \geq a \end{cases} \qquad (7)$$

und zum anderen unter ii) in der Form

$$p(\xi, a) = \begin{cases} (a-\xi)^{-k}, & \xi \in [\xi_{min}; a[ \,, & k \in \mathbb{N} \\ \\ \infty & , & \xi \geq a \end{cases} \qquad (8)$$

Die Bestrafungsfunktion p($\xi$, a) ist jeweils derart formuliert, dass dessen Funktionswert für die Annäherung von entsprechenden Eigenschaften des Projektionsobjektivs 16 an die Grenze a, d.h. an die jeweiligen Grenzwerte $a_j$, gegen "unendlich" läuft. Dieses Verhalten wird in der Bestrafungsfunktion p($\xi$, a) gemäß Ausdruck (7) durch die Verwendung einer Logarithmusfunktion 47a und in der Bestrafungsfunktion p($\xi$, a) gemäß Ausdruck (8) durch die Verwendung einer gebrochen rationalen Funktion 47b, jeweils für $\xi$ im Bereich [$\xi_{min}$; a[, bewirkt, wobei $\xi_{min}$ den kleinsten zugelassenen Wert für $\xi$ bezeichnet. Für $\xi$ = a oder Werte von $\xi$, welche die Grenze a überschreiten, gilt: p($\xi$, a) = oo. Bei der in Ausdruck (7) verwendeten Logarithmusfunktion kann es sich beispielsweise um den natürlichen, den dekadischen oder einen Logarithmus zu einer anderen (insbesondere positiven) Basis handeln.

Sowohl die im Ausdruck (7) verwendete Logarithmusfunktion 47a als auch die im Ausdruck (8) verwendete gebrochen rationale Funktion 47b ist in beiden Variablen mehrfach stetig differenzierbar. Dies gilt für einen erlaubten Bereich. Dieser erlaubte Bereich kann den gesamten Definitionsbereich der betreffenden Funktion umfassen, welcher im vorliegenden Fall der gesamte Bereich ist, in dem der Wert der Logarithmusfunktion 47a bzw. der gebrochen rationalen Funktion nicht unendlich wird. Gemäß einer Ausführungsform wird der aus mathematischer Sicht maximal mögliche Definitionsbereich durch praktische Randbedingungen beschränkt. Darunter ist zu verstehen, dass das Funktionsargument aufgrund von Randbedingungen des Manipulationssystems und/oder der Projektionsbelichtungsanlage in der Praxis nicht alle Werte des aus mathematischer Sicht maximal möglichen Definitionsbereichs annehmen kann. So kann etwa ein Bildfehler möglicherweise nicht ganz auf Null reduziert werden, sondern kann sich dem absoluten Wert Null nur bis zu einem bestimmten Wert annähern. Insbesondere wird ein Definitionsbereich, der aus mathematischer Sicht eine untere oder eine obere Grenze von -∞ bzw. +∞ aufweist, durch praktische Randbedingungen auf einen endlichen Zahlenwert begrenzt.

Gemäß einer weiteren Ausführungsform ist die Funktion in einem Abschnitt mehrfach stetig differenzierbar, wobei dieser Abschnitt mehr als 90%, insbesondere mehr als 98%, mehr als 99%, mehr als 99,9% oder mehr als 99,99% des durch praktische Randbedingungen beschränkten Definitionsbereichs der Funktion ausmacht.

Diese Beschränkung der Differenzierbarkeit auf den genannten Abschnitt gilt insbesondere für den Fall, in dem die Funktion in numerischer Darstellung vorliegt. Dabei ist die einmalige stetige Differenzierbarkeit gemäß einer Ausführungsform dadurch erfüllt, dass an jedem Punkt des o.g. Abschnitts, dessen Funktionswert das 10-fache der kleinsten in einem Rechenprogramm der Steuerungsvorrichtung 14 darstellbaren Zahl übersteigt, ein durch lineare Approximation bestimmter Funktionswert eines zugeordneten Approximationspunktes um höchstens 50%, insbesondere um höchstens 20%, um höchstens 10%, um höchstens 5% oder um höchstens 1%, vom tatsächlichen Funktionswert abweicht, wobei der dem jeweiligen Punkt zugeordnete Approximationspunkt um mindestens das Doppelte, das Fünffache oder das Zehnfache einer Mindestschrittweite von dem Punkt beabstandet ist.

Gemäß einer Ausführungsform ist die zweimalige stetige Differenzierbarkeit der in numerischer Darstellung vorliegenden Funktion dadurch erfüllt, dass an jedem Punkt des Abschnitts, dessen Funktionswert das 10-fache der kleinsten im Rechenprogramm der Steuerungsvorrichtung 14 darstellbaren Zahl übersteigt, ein durch quadratische Approximation bestimmter Funktionswert eines zugeordneten Approximationspunktes um höchstens 50%, insbesondere um höchstens 20%, u höchstens 10%, um höchstens 5% oder um höchstens 1%, vom tatsächlichen Funktionswert abweicht, wobei der dem jeweiligen Punkt zugeordnete Approximationspunkt um mindestens das Doppelte, insbesondere um mindestens das Fünffache oder um mindestens das Zehnfache der Mindestschrittweite von dem Punkt beabstandet ist. Dies gilt für jeden Punkt des o.g. Abschnitts, dessen Funktionswert das 1000-fache oder $10^6$-fache der kleinsten im Rechenprogramm der Steuerungsvorrichtung darstellbaren Zahl übersteigt.

Allgemein ausgedrückt, beruht die mathematische Definition der Differenzierbarkeit auf dem Grenzwert des Differenzenquotienten für beliebig kleine Änderungen des Funktionsarguments. Bei numerischen Rechnungen mit endlicher Genauigkeit der Zahlendarstellung kann dieser Grenzwert nicht streng betrachtet werden. Wesentlich für die numerische Anwendung ist vielmehr, dass sich eine stetig differenzierbare Funktion $f(x)$ um jeden Punkt $x_0$ des Definitionsbereichs in einem gewissen Bereich um diesen Punkt $x_0$ herum mit vorgegebener Genauigkeit bzw. maximaler Abweichung $\Delta f$ durch eine lineare Funktion $\tilde{f}(x) = f(x_0) + \hat{\tilde{f}}_1(x_0) \cdot (x - x_0)$ mit einem geeigneten, im Allgemeinen von $x_0$ abhängigen Steigungsfaktor $\hat{f}_1(x_0)$ approximieren lässt, wobei die Differenzierbarkeit erlaubt, $\hat{f}_1(x_0) = \left. \frac{d}{dx} f(x) \right|_{x=x_0}$ zu setzen. Es gilt dann: $\|f(x) - f(x)\| < \Delta f$ für $x \in \, ]x_0 - \varepsilon_1, \, x_0 + \varepsilon_1[$ mit $\varepsilon_1 > 0$. Die Größe $\varepsilon_1$ gibt einen "Mindestradius" des Bereichs um $x_0$ an, in dem die Funktion mit der vorgegebenen Höchstabweichung $\Delta f$ linear genähert werden kann. Dieser "Mindestradius" kann abhängig vom Punkt $x_0$ verschieden groß gewählt werden. Wie vorstehend erwähnt, sollte er im überwiegenden Definitionsbereich der Funktion größer sein als das Doppelte der kleinsten Schrittweite der Zahlendarstellung, d.h. der Mindestschrittweite. Naturgemäß sollte dieser Bereich in der Nähe einer Unendlichkeitsstelle der Funktion, wie sie für die Funktionen $p(\xi, a)$ gefordert wird, klein werden. Die Höchstabweichung $\Delta f$ wird gemäß der vorstehend beschriebenen Ausführungsform auf höchstens 50% des Funktionswerts $f$ festgelegt.

Ganz analog liegt in der numerischen Anwendung der Wert einer zweifachen stetigen Differenzierbarkeit in der Approximierbarkeit der Funktion durch eine Funktion

$$\tilde{\tilde{f}}(x) = f(x_0) + \tilde{\tilde{f}}_1(x_0) \cdot (x - x_0) + \tilde{\tilde{f}}_2(x_0) \cdot (x - x_0)^2$$ zweiter Ordnung mit einem geeigneten, im Allgemeinen von $x_0$ abhängigen Steigungsfaktor $\tilde{\tilde{f}}_1(x_0)$ und einer geeigneten, im Allgemeinen von $x_0$ abhängigen "Krümmung" $\tilde{\tilde{f}}_2(x_0)$. Wiederum erlaubt hier die zweifache Differenzierbarkeit, $\tilde{\tilde{f}}_1(x_0) = \left. \frac{d}{dx} f(x) \right|_{x=x_0}$ und $\tilde{\tilde{f}}_2(x_0) = \left. \frac{d^2}{dx^2} f(x) \right|_{x=x_0}$ zu setzen. Es gilt dann: $\left\| \tilde{\tilde{f}}(x) - f(x) \right\| < \Delta f$ für $x \in \, ]x_0 - \varepsilon_2, \, x_0 + \varepsilon_2[$, wobei wiederum $\varepsilon_2 > 0$ einen "Mindestradius" für den Bereich angibt, in dem die vorgegebene Genauigkeit erreicht wird.

Die Erweiterung auf zweidimensionale Funktionen wie z.B. $p(\xi,a)$ und deren Differenzierbarkeit nach $\xi$ und $a$ ist in der Mathematik allgemein bekannt, Stichworte sind beispielsweise "partielle Ableitungen" und "totale Ableitung". Die vorstehenden Ausführungen zur Differenzierbarkeit sind für die numerische Anwendung unter Berücksichtigung der Rechengenauigkeit zu verstehen.

Weiterhin Bezug nehmend auf Fig. 2, ermöglicht es die Verfügbarkeit der ersten Ableitung der Bestrafungsfunktion $p(\xi, a)$ im Bereich $[\xi_{min}; a[$ dem Optimierungsalgorithmus 41 per Gradientenverfahren ins Ziel zu finden. Durch die Verfügbarkeit der zweiten, insbesondere noch höheren, Ableitung der Bestrafungsfunktion $p(\xi, a)$ im Bereich $[\xi_{min}; a[$ kann das per Gradientenverfahren ermittelte Ziel in besonders kurzer Zeit, beispielsweise mit großer Schrittweite, aufgefunden werden.

Wie aus dem vorstehenden Ausdruck (4) ersichtlich, umfasst die Gütefunktion H weiterhin einen zweiten Bestrafungsterm 48 der Form

$$\sum_j \Gamma_{t_j} \left| t_j \right|^2 \qquad\qquad (9)$$

Dieser Term dient der Begrenzung der Skalierungsfaktoren $t_j$. Durch geeignete Vorgabe des Parameters $\Gamma_{t_j}$ kann dabei das Maß der Begrenzung eingestellt werden. Dabei kann gemäß einer Ausführungsform ein Gruppengrenzwert vorgesehen sein, welcher von zumindest einem Teil der den Skalierungsfaktoren $t_j$ zugeordneten Einzelgrenzwerten $a_j$ nicht überschritten werden darf. Gemäß einer weiteren Ausführungsform ist der Bestrafungsterm 48 dazu konfiguriert, sowohl die Werte der Skalierungsfaktoren $t_j$ als auch des Gruppengrenzwerts zu begrenzen. Weiterhin können auch mehrere Gruppengrenzwerte sowie ein Übergruppengrenzwert vorgesehen sein, wobei die Gruppengrenzwerte unterschiedliche Gruppen an Skalierungsfaktoren $t_j$ betreffen und der Übergruppengrenzwert von keinem der Gruppengrenzwerte überschritten werden darf. Gemäß einer weiteren Ausführungsform kann die Gütefunktion 42 einen weiteren Bestrafungsterm zur Begrenzung des Gruppengrenzwerts umfassen. Das beschriebene Konzept kann auf weitere Kaskadierungen mit Über-Übergruppengrenzwerten erweitert werden.

Die im Ausdruck (4) dargestellte Gütefunktion H kann neben dem Bestrafungstermen 46 (Ausdruck (5)) und dem Bestrafungsterm 48 (Ausdruck (9)) optional den Ausdruck $\|Mx - b\|_2^2$ umfassen, wobei b eine vektorielle Darstellung der Zernike-Koeffizienten $b_i$ ist und $\| \|_2$ die Euklidische Norm bezeichnet. Weiterhin kann die Gütefunktion H optional weitere Bestrafungsterme etwa zur Berücksichtigung von Fading-Aberrationen, von Overlay-Fehlern, von Randbedingungen des Manipulatorsystems M1 bis M4, von Randbedingungen der mittels der Nachbearbeitungseinrichtung 36 vorzunehmenden Korrekturasphären-Abtragungen und/oder von gruppierten RMS-Werten der Zernike-Koeffizienten $b_j$ umfassen. Unter einer Fading-Aberration ist eine Angabe zu verstehen, wie sich ein Bildfehler in Scanrichtung einer Projektionsbelichtungsanlage, d.h. in Richtung der Relativbewegung zwischen Maske und Wafer, bei der Belichtung ändert. Ein Overlay-Fehler gibt eine lokale Bildlageverschiebung einer abgebildeten Maskenstruktur gegenüber deren Solllage auf dem Substrat an.

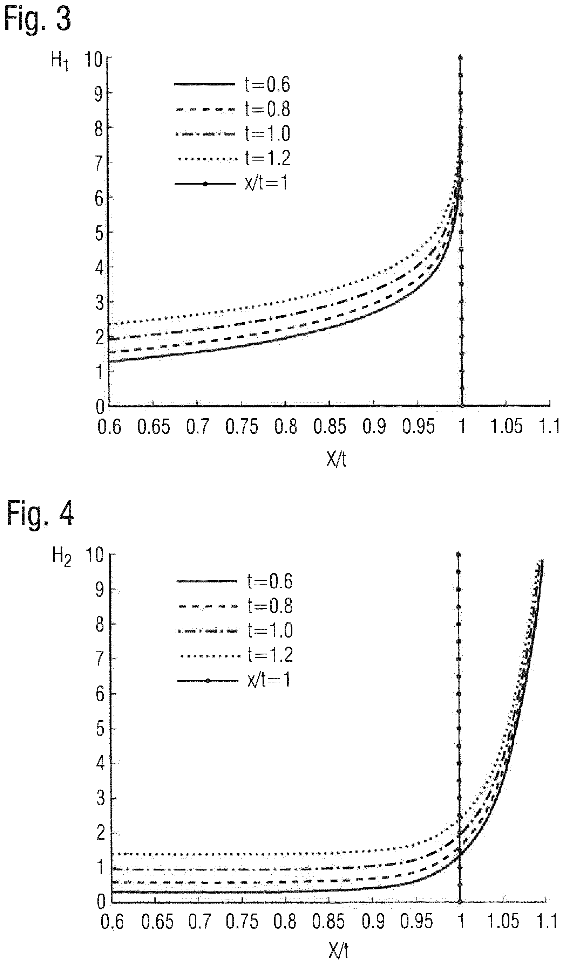

Die Figuren 3 und 4 dienen der Veranschaulichung der Wirkungsweise der auf der erfindungsgemäßen Gütefunktion H(x, t) beruhenden Optimierung. Hierzu wird im Diagramm gemäß Fig. 3 der Wert der aus der Summe der Bestrafungsterme 46 und 48 gebildeten Gütefunktion, welche hier mit $H_1$ bezeichnet wird, bei Annäherung von $\xi$ an die Grenze a dargestellt. Dazu wird als Bestrafungsfunktion $p(\xi, a)$ die unter (7) dargestellte Ausführungsvariante i) gewählt.

Zur Darstellung im Diagramm von Fig. 3 wird die folgende Ersetzung vorgenommen: $\chi := \dfrac{|Mx - b|}{s}$, wobei s der Darstellung der Gesamtheit der Ausgangsgrenzwerte $s_j$ dient. Mit dieser Ersetzung und der Wahl k=1 und $\xi_{min}$=0 ergibt sich für $H_1$ im Bereich $\xi \in [\xi_{min}; a[$ der folgende Ausdruck:

$$H_1(\chi, t) = -\log\left(1 - \frac{\chi}{t}\right) + \Gamma t^2 \qquad (10)$$

Im Diagramm von Fig. 3 ist der Wert von $H_1$ in Abhängigkeit von $\chi/t$ für verschiedene Werte von t dargestellt, wobei $\Gamma$=1 gesetzt wird. Eine Annäherung von $\xi$ an die Grenze a entspricht im Diagramm einer Annäherung von $\chi/t$ an den Wert "1". Wie aus dem Diagramm ersichtlich, verläuft die Kurve für alle dargestellten t-Werte bei Annäherung von $\chi/t$ an den Wert 1 gegen "unendlich". Das heißt, $H_1$ ist so konfiguriert, dass eine Verletzung der mit t skalierten Ausgangsgrenzwerte $s_j$ verhindert wird.

Zum Vergleich hierzu ist in dem Diagramm gemäß Fig. 4 der Wert einer aus dem Stand der Technik abgeleiteten Gütefunktion $H_2$ bei Annäherung von $\xi$ an die Grenze a dargestellt. Diese Gütefunktion lautet:

$$H_2(x, t) = \left(\frac{|Mx - b|}{t \cdot s}\right)^{2N} + \Gamma t^2 ; \qquad N \in \mathbb{N} \qquad (11)$$

Der erste Term $\left(\dfrac{|Mx - b|}{t \cdot s}\right)^{2N}$ der Gütefunktion $H_2$ beruht auf einer aus dem Stand der Technik bekannten und eingangs in diesem Text erwähnten Gütefunktion mit einer auf einer Potenz mit einem geradzahligen Exponenten beruhenden Bestrafungsfunktion. Diese vorbekannte Bestrafungsfunktion wird hier dahingehend modifiziert, dass mit t eine Skalierungsgröße für die Grenze a eingeführt und neben $\chi$ als weitere Optimierungsvariable vorgesehen wird. Bei Vornahme der vorstehend bereits bezüglich $H_1$ erläuterten Ersetzung $\chi := \dfrac{|Mx - b|}{s}$ ergibt sich:

$$H_2(\chi, t) = \left(\frac{\chi}{t}\right)^{2N} + \Gamma t^2 \qquad (12)$$

Im Diagramm von Fig. 4 ist $H_2$ analog zu $H_1$ gemäß Fig. 3 in Abhängigkeit von $\chi/t$ für verschiedene Werte von t dargestellt, wobei $\Gamma=1$ und $N=12$ gesetzt wird. Bei Annäherung von $\xi$ an die Grenze a, was im Diagramm der Annäherung von $\chi/t$ an den Wert "1" entspricht, steigt der Funktionswert von $H_2$ zwar erheblich an, aber nicht so stark, dass ein Überschreiten des Werts "1" zuverlässig verhindert würde. Das heißt, mit der Gütefunktion $H_2$ wird eine Verletzung der mit t skalierten Ausgangsgrenzwerte $s_j$ nicht mit ausreichender Verlässlichkeit verhindert.

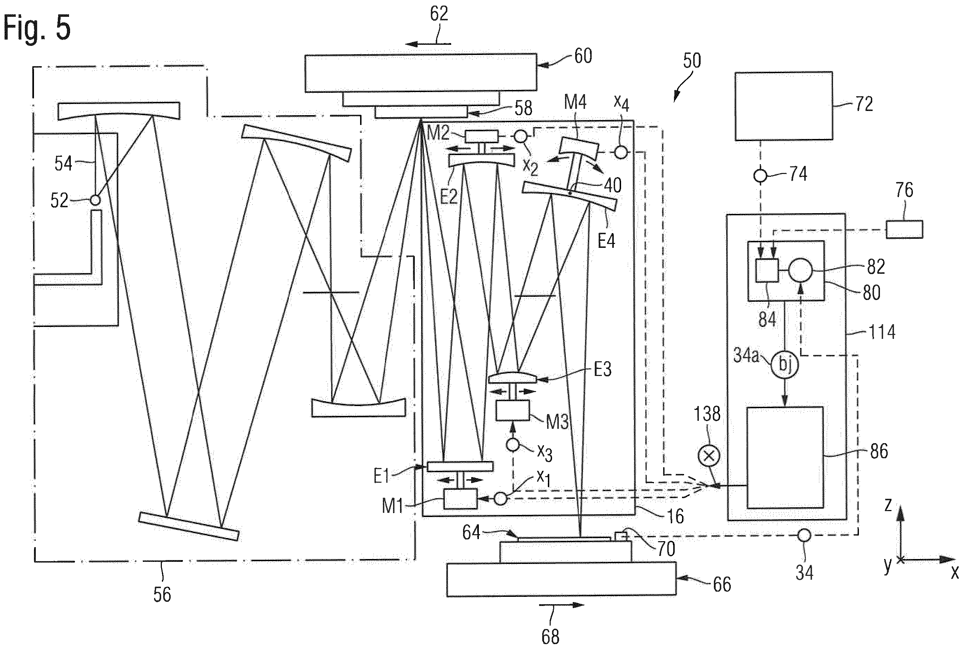

Fig. 5 zeigt eine erfindungsgemäße Ausführungsform einer Projektionsbelichtungsanlage 50 für die Mikrolithographie. Die vorliegende Ausführungsform ist zum Betrieb im EUV-Wellenlängenbereich ausgelegt. Aufgrund dieser Betriebswellenlänge sind alle optischen Elemente als Spiegel ausgeführt. Die Erfindung ist jedoch nicht auf Projektionsbelichtungsanlagen im EUV-Wellenlängenbereich begrenzt. Weitere erfindungsgemäße Ausführungsformen sind beispielsweise auf Betriebswellenlängen im UV-Bereich, wie beispielsweise 365 nm, 248 nm oder 193 nm ausgelegt. In diesem Fall sind zumindest einige der optischen Elemente als herkömmliche Transmissionslinsen konfiguriert.

Die Projektionsbelichtungsanlage 50 gemäß Fig. 5 umfasst eine Belichtungsstrahlungsquelle 52 zur Erzeugung von Belichtungsstrahlung 54. Im vorliegenden Fall ist die Belichtungsstrahlungsquelle 52 als EUV-Quelle ausgeführt und kann beispielsweise eine Plasmastrahlungsquelle umfassen. Die Belichtungsstrahlung 54 durchläuft zunächst eine Beleuchtungsoptik 56 und wird von dieser auf eine Maske 58 gelenkt. Die Beleuchtungsoptik 56 ist dazu konfiguriert, unterschiedliche Winkelverteilungen der auf die Maske 58 auftreffenden Belichtungsstrahlung 54 zu erzeugen. Abhängig von einer vom Benutzer gewünschten Beleuchtungseinstellung, auch "Beleuchtungssetting" genannt, konfiguriert die Beleuchtungsoptik 56 die Winkelverteilung der auf die Maske 58 auftreffenden Belichtungsstrahlung 54. Beispiele für wählbare Beleuchtungseinstellungen umfassen eine sogenannte Dipol-Beleuchtung, annulare Beleuchtung und Quadrupolbeleuchtung.

Die Maske 58 weist Maskenstrukturen zur Abbildung auf ein Substrat 64 in Gestalt eines Wafers auf und ist auf einer Maskenverschiebebühne 60 verschiebbar gelagert. Die Maske 58 kann, wie in Fig. 5 dargestellt, als Reflexionsmaske ausgeführt sein oder alternativ, insbesondere für die UV-Lithographie, auch als Transmissionsmaske konfiguriert sein. Die Belichtungsstrahlung 54 wird in der Ausführungsform gemäß Fig. 5 an der Maske 58 reflektiert und durchläuft daraufhin das bereits unter Bezugnahme auf die Justieranordnung 10 gemäß Fig. 1 beschriebene Projektionsobjektiv 16. Das Projektionsobjektiv 16 dient dazu, die Maskenstrukturen der Maske 58 auf das Substrat 64 abzubilden. Die Belichtungsstrahlung 54 wird innerhalb des Projektionsobjektivs 16 mittels einer Vielzahl von optischen Elementen, vorliegend in Gestalt von Spiegeln, geführt. Das Substrat 64 ist auf einer Substratverschiebebühne 66 verschiebbar gelagert. Die Projektionsbelichtungsanlage 50 kann als sogenannter Scanner oder als sogenannter Stepper ausgeführt sein.

Im Fall der Ausführung als Scanner, auch Step- und Scan-Projektionsbelichtungsanlage genannt, werden bei jeder Abbildung der Maske 58 auf das Substrat 64, d.h. bei jeder Belichtung eines Feldes auf dem Substrat 64, die Maskenverschiebebühne 60 sowie die Substratverschiebebühne 66 koordiniert bewegt. Wie in Fig. 5 gezeigt, bewegt sich dabei die Maskenverschiebebühne 60 in eine Scanrichtung 62 und die Substratverschiebebühne in eine Scanrichtung 68. Die vorstehend erläuterten Fading-Aberrationen sind auf die Scanbewegungen während der Feldbelichtung eines derartigen Scanners zurückzuführen.

Die Projektionsbelichtungsanlage 50 umfasst weiterhin eine zentrale Steuerungseinrichtung 72 zur Steuerung des Belichtungsvorganges, einschließlich der Maskenverschiebebühne 60 sowie der Substratverschiebebühne 66. Darüber umfasst die Projektionsbelichtungsanlage 50 eine Steuerungsvorrichtung 114 zur Steuerung der Manipulatoren M1 bis M4. Die Steuerungsvorrichtung 114 wiederum umfasst einen Zustandsgeber 80 sowie einen Stellwegsermittler 86. Der Zustandsgeber 80 übergibt aktuelle Zustandscharakterisierungen 34a des Projektionsobjektivs 16 an den Stellwegsermittler 86, welcher daraus einen Stellwegbefehl 138 erzeugt. Der Stellwegbefehl 138 umfasst Stellwege $x_i$, im gezeigten Fall die Stellwege $x_1$, $x_2$, $x_3$ sowie $x_4$. Diese Stellwege dienen der Steuerung der Manipulatoren M1 bis M4, wie vorstehend in Bezug auf die Justieranordnung 10 gemäß Fig. 1 näher beschrieben.

Der vom Stellwegsermittler 86 erzeugte Stellwegbefehl 138 umfasst von den Manipulatoren M1 bis M4 auszuführende Veränderungen in Form von Stellwegen $x_i$ entsprechender Zustandsgrößen der optischen Elemente E1 bis E4. Die ermittelten Stellwege $x_i$ werden den einzelnen Manipulatoren M1 bis M4 über Stellwegsignale übermittelt und geben diesen jeweilige auszuführende Korrekturstellwege vor. Diese definieren entsprechende Verlagerungen der zugeordneten optischen Elemente E1 bis E4 zur Korrektur aufgetretener Wellenfrontfehler des Projektionsobjektivs 16. Zur Ermittlung der Stellwege $x_i$ erhält der Stellwegsermittler 86 vom Zustandsgeber 80, insbesondere während der Ausführung des Belichtungsvorganges, jeweils aktualisierte Zustandscharakterisierungen 34a in Gestalt von die Wellenfront charakterisierenden Zernike-Koeffizienten $b_j$.

Der Stellwegsermittler 86 erzeugt gemäß einer Ausführungsform während der Belichtung eines Substrats 64 mehrfach aktualisierte Stellwege $x_i$. Gemäß einer Ausführungsform weist der Zustandsgeber 80 einen Speicher 82 sowie eine Simulationseinrichtung 84 auf. Im Speicher 82 werden Zustandscharakterisierungen 34 in Gestalt von Aberrationsparametern abgespeichert, die mittels einer Wellenfrontmessung an dem Projektionsobjektiv 16 ermittelt worden sind. Diese Messergebnisse können mittels einer externen Wellenfrontmessvorrichtung, wie der in Bezug auf Fig. 1 beschriebenen Messvorrichtung 12, erhoben werden. Alternativ können die Zustandscharakterisierungen 34 aber auch von einer in der Substratverschiebebühne 66 integrierten Wellenfrontmesseinrichtung 70 gemessen werden. Eine derartige Messung kann etwa regelmäßig nach jeder Belichtung eines Wafers oder jeweils nach Belichtung eines kompletten Wafersatzes erfolgen. Alternativ kann anstatt einer Messung auch eine Simulation bzw. eine Kombination aus Simulation und reduzierter Messung vorgenommen werden.

Die im Speicher 82 abgelegten Messwerte der Zustandscharakterisierung 34 in Gestalt von Aberrationsparametern in Form von Zernike-Koeffizienten werden ggf. von der Simulationseinrichtung 84 an jeweilige aktualisierte Verhältnisse während des Belichtungsvorganges angepasst. Gemäß einer Ausführungsvariante wird der Simulationseinrichtung 84 dazu regelmäßig von der zentralen Steuerungseinrichtung 72 die aktuelle Bestrahlungsintensität 74 übermittelt. Die Simulationseinrichtung 84 berechnet daraus unter Zugrundelegung der jeweiligen Beleuchtungseinstellung aufgrund von Linsenaufheizung bewirkte Änderungen in den Aberrationsparametern. Weiterhin erhält die Simulationseinrichtung laufend Messwerte eines den Umgebungsdruck der Projektionsbelichtungsanlage 50 überwachenden Drucksensors 76. Auswirkungen von Veränderungen im Umgebungsdruck auf die Aberrationsparameter werden von der Simulationseinrichtung 84 berücksichtigt.

Die Steuerungsvorrichtung 114 der Projektionsbelichtungsanlage 50 gemäß Fig. 5 unterscheidet sich von der Steuerungseinrichtung 14 der Justieranordnung 10 gemäß Fig. 1 dadurch, dass die Steuerungsvorrichtung 114 mittels des Zustandsgebers 80 die von einer Wellenfrontmesseinrichtung gemessene Zustandscharakterisierung 34 unter Verwendung der aktuellen Beleuchtungsintensität 74 in eine aktuelle Zustandscharakterisierung 34a umwandelt. Die Funktion des Stellwegsermittlers 86 der Steuerungsvorrichtung 114 entspricht der Funktion der Steuerungseinrichtung 14, allerdings mit der Einschränkung, dass der von der Steuerungsvorrichtung 114 erzeugte Stellwegsbefehl 138 lediglich die Stellwegsvariable **x** mit den Stellwegen $x_i$ der Manipulatoren, nicht jedoch den Stellwegvektor $x^L$ zur Steuerung der Korrekturasphären-Nachbearbeitungseinrichtung 36 umfasst. Die unter Bezugnahme auf die Figuren 2 bis 4 beschriebenen Eigenschaften der Steuerungseinrichtung 14 der Justieranordnung 10 treffen analog auf die Eigenschaften des Stellwegsermittlers 86 der Steuerungsvorrichtung 114 zu.

Die vorstehende Beschreibung beispielhafter Ausführungsbeispiele, Ausführungsformen bzw. Ausführungsvarianten ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen, insoweit sie in den Rahmen der Erfindung gemäß der Definition in den beigefügten Ansprüchen fallen, sowie Äquivalente vom Schutz der Ansprüche abgedeckt sein.

Bezugszeichenliste

10    Justieranordnung
12    Messvorrichtung
14    Steuerungsvorrichtung
16    Projektionsobjektiv
18    Beleuchtungseinrichtung
20    Messstrahlung
22    Messmaske
24    Objektebene
26    Sensorelement
28    Bildebene
30    Detektor
32    Auswerteeinrichtung
34    Zustandscharakterisierung
34a    aktuelle Zustandscharakterisierung
36    Nachbearbeitungseinrichtung
38    Stellwegbefehl in Form einer Stellwegsvariablen x
40    Kippachse
41    Optimierungsalgorithmus
42    Gütefunktion H
43    Skalierungsgröße t
43a    Skalierungsfaktor $t_j$
44    Grenze a
45    Optimierungsvariablen
46    erster Bestrafungsterm
47    Bestrafungsfunktion

47a    Logarithmusfunktion
47b    gebrochen rationale Funktion
48    zweiter Bestrafungsterm
50    Projektionsbelichtungsanlage
52    Belichtungsstrahlungsquelle
54    Belichtungsstrahlung
56    Beleuchtungsoptik
58    Maske
60    Maskenverschiebebühne
62    Scanrichtung der Maskenverschiebebühne
64    Substrat
66    Substratverschiebebühne
68    Scanrichtung der Substratverschiebebühne
70    Wellenfrontmesseinrichtung
72    zentrale Steuerungseinrichtung
74    aktuelle Bestrahlungsintensität
76    Drucksensor
80    Zustandsgeber
82    Speicher
84    Simulationseinrichtung
86    Stellwegsermittler
114    Steuerungsvorrichtung
138    Stellwegbefehl
E1 - E4    optische Elemente
M1 -    M4 Manipulatoren
$x_i$    Stellwege für Manipulatoren

$x_n^L$    Stellwege für Korrekturasphären-Nachbearbeitungseinrichtung

**Patentansprüche**

1.  Steuerungsvorrichtung (14, 114) zur Steuerung mindestens eines Manipulators (M1-M4, 36) zur Veränderung eines Parameters einer Projektionsbelichtungsanlage (50) für die Mikrolithographie durch Generierung einer Vorgabe für eine Stellwegsvariable (38, 138), welche eine mittels des Manipulators vorzunehmende Veränderung des Parameters definiert,
wobei die Steuerungsvorrichtung dazu konfiguriert ist, aus einer Zustandscharakterisierung (34) der Projektionsbelichtungsanlage die Vorgabe (38) durch Optimierung einer Gütefunktion (42) zu generieren, die Gütefunktion mindestens einen Bestrafungsterm (46) zur Berücksichtigung einer Grenze (44) für eine Eigenschaft der Projektionsbelichtungsanlage als implizite Nebenbedingung umfasst und der Bestrafungsterm derart formuliert ist, dass dessen Funktionswert für die Annäherung der Eigenschaft an die Grenze gegen "unendlich" läuft.

2.  Steuerungsvorrichtung nach Anspruch 1,
bei welcher der Bestrafungsterm (46) eine Funktion (47) umfasst, welche zumindest in einem Abschnitt mindestens einmal stetig differenzierbar ist.

3.  Steuerungsvorrichtung nach Anspruch 2,
bei welcher die Funktion in numerischer Darstellung mit einer Mindestschrittweite vorliegt, wobei die stetige Differenzierbarkeit dadurch erfüllt ist, dass an jedem Punkt des Abschnitts, dessen Funktionswert das 10-fache der kleinsten in einem Rechenprogramm der Steuerungsvorrichtung darstellbaren Zahl übersteigt, ein durch lineare Approximation bestimmter Funktionswert eines zugeordneten Approximationspunktes um höchstens 50% vom tatsächlichen Funktionswert abweicht, wobei der dem jeweiligen Punkt zugeordnete Approximationspunkt um mindestens das Doppelte der Mindestschrittweite von dem Punkt beabstandet ist.

4.  Steuerungsvorrichtung nach Anspruch 2 oder 3,
bei welcher die Funktion (47) in zumindest dem Abschnitt mindestens zweimal stetig differenzierbar ist.

**5.** Steuerungsvorrichtung nach einem der Ansprüche 2 bis 4,
bei welcher die Funktion (47) zumindest näherungsweise eine Logarithmusfunktion (47a) umfasst.

**6.** Steuerungsvorrichtung nach einem der Ansprüche 2 bis 5,
bei welcher die Funktion (47) zumindest näherungsweise eine gebrochen-rationale Funktion (47b) umfasst.

**7.** Steuerungsvorrichtung nach einem der vorausgehenden Ansprüche,
bei welcher der Bestrafungsterm (46) derart formuliert ist, dass dessen Funktionswert bei Überschreiten der Grenze (44) als "unendlich" definiert ist.

**8.** Steuerungsvorrichtung nach einem der vorausgehenden Ansprüche,
bei der die Steuerungsvorrichtung (14, 114) dazu konfiguriert ist, die Vorgabe durch Optimierung der Gütefunktion mittels der als erste Optimierungsvariable dienenden Stellwegsvariablen (38) sowie mittels einer weiteren Optimierungsvariablen (43) einer anderen Kategorie durchzuführen.

**9.** Steuerungsvorrichtung nach Anspruch 8,
bei der die weitere Optimierungsvariable (43) einen Skalierungsfaktor (43a) zur Skalierung der Grenze (44) umfasst.

**10.** Steuerungsvorrichtung nach Anspruch 9,
bei der die Gütefunktion (42) einen weiteren Bestrafungsterm (48) zur Begrenzung des Wertes des Skalierungsfaktors (43a) umfasst.

**11.** Steuerungsvorrichtung nach einem der Ansprüche 8 bis 10,
bei der die Grenze (44) eine Mehrzahl an Einzelgrenzwerten für eine jeweilige Eigenschaft der Projektionsbelichtungsanlage umfasst und die weitere Optimierungsvariable eine Mehrzahl an Skalierungsfaktoren (43a) zur Skalierung der Einzelgrenzwerte sowie einen Gruppengrenzwert umfasst, welcher von zumindest einem Teil der Einzelgrenzwerte nicht überschritten werden darf.

**12.** Steuerungsvorrichtung nach einem der vorausgehenden Ansprüche,
bei der die Eigenschaft der Projektionsbelichtungsanlage, für die der Bestrafungsterm (46) eine Grenze umfasst, einen Abbildungsfehler (34) eines Projektionsobjektivs der Projektionsbelichtungsanlage aufweist.

**13.** Steuerungsvorrichtung nach einem der vorausgehenden Ansprüche,
bei der die Eigenschaft der Projektionsbelichtungsanlage, für die der Bestrafungsterm (46) eine Grenze umfasst, die Vorgabe für die Stellwegsvariable (38) aufweist.

**14.** Justieranordnung (10) zur Justierung eines Projektionsobjektivs (16) für die Mikrolithographie,
mit einer Messvorrichtung (12) zur Ermittlung einer Zustandscharakterisierung (34) des Projektionsobjektivs sowie einer Steuerungsvorrichtung (14) nach einem der vorausgehenden Ansprüche zur Generierung der Vorgabe für eine Stellwegsvariable (38) aus der Zustandscharakterisierung.

**15.** Projektionsbelichtungsanlage (50) für die Mikrolithographie mit mindestens einen Manipulator (M1-M4), welcher dazu konfiguriert ist, einen Parameter der Projektionsbelichtungsanlage des Projektionsobjektivs zu verändern, sowie einer Steuerungsvorrichtung (114) nach einem der Ansprüche 1 bis 13 zur Steuerung des mindestens einen Manipulators.

**16.** Verfahren zum Steuern mindestens eines Manipulators (M1-M4, 114) zur Veränderung eines Parameters einer Projektionsbelichtungsanlage für die Mikrolithographie mit den Schritten:

- Generieren einer Vorgabe für eine Stellwegsvariable (38) für den mindestens einen Manipulator aus einer Zustandscharakterisierung (34) der Projektionsbelichtungsanlage durch Optimierung einer Gütefunktion (42), wobei:

die Gütefunktion mindestens einen Bestrafungsterm (46) zur Berücksichtigung einer Grenze (44) für eine Eigenschaft der Projektionsbelichtungsanlage als implizite Nebenbedingung umfasst und
der Bestrafungsterm derart formuliert ist, dass dessen Funktionswert für die Annäherung der Eigenschaft an die Grenze gegen "unendlich" läuft, sowie

- Verändern des Parameters der Projektionsbelichtungsanlage mittels des mindestens einen Manipulators anhand der generierten Vorgabe für die Stellwegsvariable.

# Fig. 1

## Fig. 2

$$H(x, t) = \cdots + \sum_j p\left(|M_j\, x - b_j|, t_j \cdot s_j\right) + \cdots \sum_j \Gamma_{t_j} |t_j|^2 + \cdots;$$

$$\text{i) } p(\xi, a) = \begin{cases} \left(-\log\left(\dfrac{a-\xi}{a-\xi_{min}}\right)\right)^k, & \xi \in [\xi_{min}; a[ \;, \; k \epsilon N \\[2em] \infty & , \; \xi \geq a \end{cases}$$

$$\text{ii) } p(\xi, a) = \begin{cases} (a-\xi)^{-k}, & \xi \in [\xi_{min}; a[ \;, \; k \epsilon N \\[2em] \infty & , \; \xi \geq a \end{cases}$$

Fig. 3

Fig. 4

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102019200218
- WO 2010034674 A1
- DE 102015206448 A1
- US 20130188246 A1

### In der Beschreibung aufgeführte Nicht-Patentliteratur

- Optical Shop Testing. John Wiley & Sons, Inc, 1992
- **H. GROSS.** Handbook of Optical Systems. Wiley-VCH Verlag GmbH & Co. KGaA, 2005, vol. 2